**Europäisches Patentamt**

**European Patent Office**

**Office européen des brevets**

(11) Numéro de publication: **0 316 221**

**A1**

# (12) DEMANDE DE BREVET EUROPEEN

(21) Numéro de dépôt: **88402780.6**

(22) Date de dépôt: **04.11.88**

(51) Int. Cl.⁴: **H 01 L 27/14**
**H 04 N 3/15**

(30) Priorité: **10.11.87 FR 8715533**

(43) Date de publication de la demande:
**17.05.89 Bulletin 89/20**

(84) Etats contractants désignés: **DE GB NL**

(71) Demandeur: **THOMSON-CSF**
**173, Boulevard Haussmann**
**F-75379 Paris Cédex 08 (FR)**

(72) Inventeur: **Berger, Jean-Luc**
**THOMSON-CSF SCPI 19, avenue de Messine**
**F-75008 Paris (FR)**

(74) Mandataire: **Guérin, Michel et al**
**THOMSON-CSF SCPI**
**F-92045 PARIS LA DEFENSE CEDEX 67 (FR)**

(54) **Matrice d'éléments photosensibles associant un phototransistor et une capacité de Stockage.**

(57) L'invention concerne les matrices photosensibles, pour la prise d'images.

On propose ici une matrice dans laquelle chaque point photosensible comporte, en série entre un conducteur de ligne (36) et un conducteur de colonne (32), une capacité en série avec un phototransistor de type NIPIN ou PINIP. Ce phototransistor peut être rendu conducteur, pour la lecture des charges stockées dans la capacité, aussi facilement qu'une photodiode, même dans l'obscurité. Le phototransistor est constitué de préférence par un empilement de couches de silicium amorphe de type N (10), de type intrinsèque (12), de type P (14), de type intrinsèque (16), et de type N (18).

Application notamment à la prise de vue radiologique avec une matrice de grandes dimensions.

FIG. 5

EP 0 316 221 A1

Bundesdruckerei Berlin

**Description**

## MATRICE D'ELEMENTS PHOTOSENSIBLES ASSOCIANT UN PHOTOTRANSISTOR ET UNE CAPACITE DE STOCKAGE

L'invention concerne les barrettes ou matrices d'éléments photosensibles.

Pour réaliser des matrices d'éléments photosensibles, il est classique de prévoir un réseau de conducteurs en ligne, et un réseau de conducteurs en colonne, avec, à chaque croisement d'une ligne et d'une colonne, un élément photosensible respectif. Par le réseau de lignes on sélectionne une ligne d'éléments photosensibles dont on veut connaître les signaux électriques de sortie; par le réseau de conducteurs de colonnes, on lit un signal de sortie respectif pour chacun des éléments de la ligne sélectionnée.

Une méthode pour permettre la sélection individuelle d'une ligne et la lecture individuelle sur chaque colonne consiste à utiliser en chaque point de la matrice l'association d'un élément photosensible proprement dit et d'un transistor d'accès. L'élément photosensible est une photodiode ou un phototransistor (ce dernier ayant l'avantage d'une plus grande sensibilité, c'est-à-dire qu'il fournit une charge électrique supérieure pour un même éclairement). Cette photodiode est reliée par l'intermédiaire du transistor d'accès à un conducteur de colonne de la matrice. Ce transistor est commandé par un conducteur de ligne (et tous les éléments photosensibles de la même ligne sont ainsi connectés au même conducteur de ligne).

L'inconvénient de ce type de structure est qu'il nécessite en chaque point de la matrice à la fois une photodiode et un transistor d'accès disposé à côté de la photodiode; cette structure est encombrante à cause de la surface consommée par le transistor d'accès en chaque point de la matrice.

Pour réduire l'encombrement, c'est-à-dire en fait pour augmenter la résolution en logeant un plus grand nombre de points dans une surface donnée, on a proposé des structures dans lesquelles le transistor d'accès est supprimé et remplacé par une capacité servant d'une part à stocker les charges engendrées par la photodiode et d'autre part à isoler la photodiode du conducteur de colonne lorsque la ligne correspondant à cette photodiode n'est pas sélectionnée.

Une telle structure est décrite par exemple dans le brevet français 86 00716. L'avantage de la capacité par rapport au transistor est qu'elle peut être disposée au dessus et non à côté de la photodiode, ce qui réduit l'encombrement.

L'inconvénient est que la lecture des charges stockées en chaque point ne peut plus se faire aussi simplement que lorsqu'on a un transistor d'accès qu'il suffit de rendre conducteur pour connecter la photodiode à un conducteur de colonne de la matrice. Avec une structure ne comportant plus qu'une photodiode et une capacité, c'est la photodiode elle-même qu'il faut rendre conductrice, en la polarisant en direct, pendant le bref instant que dure la lecture, de manière à évacuer vers le conducteur de colonne les charges stockées dans la capacité (ou à amener par le conducteur de colonne une charge de compensation des charges stockées).

Il est important de noter que ce type de structure interdit a priori l'usage de phototransistors à la place de photodiodes, car, contrairement à la photodiode qui peut être rendue conductrice par simple polarisation en direct sous une faible tension, le phototransistor ne peut pas être rendu aisément conducteur sans action sur sa base. Or, sa base est a priori flottante (si elle ne l'était pas on retomberait dans une structure complexe qu'on cherchait à éviter). Pour le rendre conducteur dans l'obscurité sans action sur la base, il faudrait faire passer en avalanche sa jonction base-émetteur en lui appliquant une tension élevée entre collecteur et émetteur, et cela est d'autant moins souhaitable que cela introduirait un bruit considérable dans le signal qu'on veut lire.

Pourtant, il serait souhaitable d'utiliser un phototransistor à la place d'une photodiode pour augmenter la sensibilité du dispositif sans perdre sur la résolution. On comprendra en effet que si on cherche à réduire l'encombrement, cela suppose qu'on utilise une photodiode aussi petite que possible, mais la sensibilité est proportionnelle à la surface de la photodiode.

Pour obtenir un meilleur compromis entre sensibilité et résolution, la présente invention propose d'utiliser une matrice d'éléments photosensibles dans laquelle chaque point de la matrice comporte, entre un conducteur de ligne et un conducteur de colonne, une capacité en série avec un élément photosensible constitué par un phototransistor susceptible d'être rendu conducteur aussi facilement qu'une photodiode même dans l'obscurité; la structure préférentielle de ce phototransistor est une superposition de couches semiconductrices alternativement dopées de la manière suivante:
- dopage d'un premier type de conductivité;
- absence de dopage (semiconducteur intrinsèque ou quasi-intrinsèque);
- dopage du deuxième type de conductivité;
- absence de dopage (semiconducteur intrinsèque ou quasi-intrinsèque);
- dopage du premier type de conductivité;
l'élément photosensible est connecté en série avec une capacité comportant une couche diélectrique en contact avec l'une des couches semiconductrices extrêmes de la superposition, et l'ensemble en série du phototransistor et de la capacité est placé entre un conducteur de ligne et un conducteur de colonne.

Par absence de dopage on entend ici l'absence de dopage susceptible d'augmenter la teneur en porteurs libres ; mais cela n'exclut pas un dopage à l'hydrogène ou au carbone pour des raisons que l'on expliquera plus loin.

Bien qu'une structure de phototransistor à cinq couches superposées puisse être considérée comme connue, elle trouve ici une application inattendue dans une structure de matrice sans transistor d'accès alors que l'utilisation d'un phototransistor est a priori incompatible avec une telle structure de matrice.

Le phototransistor peut être réalisé par empilement local de cinq couches superposées et la capacité est également superposée au même endroit, ce qui permet de minimiser l'encombrement de chaque point de la matrice.

L'expérience montre que, contrairement aux autres structures connues de phototransistor, cette structure à cinq couches peut être incorporée à une matrice sans transistor d'accès. Or la sensibilité du phototransistor à cinq couches NIPIN ou PINIP est supérieure à celle d'une photodiode classique de type PIN pour une surface équivalente. La mise en conduction du phototransistor pour la lecture des charges stockées sur la capacité peut se faire facilement par application d'une faible tension de polarisation (du même ordre de grandeur que pour une photodiode PIN), ceci même dans l'obscurité; de plus, cette mise en conduction ne s'accompagne pas de l'injection d'un bruit important (signal parasite non généré par l'éclairement du phototransistor) sur le conducteur de colonne.

L'une des deux couches intrinsèques est beaucoup moins épaisse que l'autre, de préférence au moins dix fois plus faible; la couche la moins épaisse a de préférence une épaisseur de l'ordre de 200 angströms ou moins.

La couche diélectrique de la capacité peut être placée soit du côté de la couche intrinsèque mince soit du côté de la couche intrinsèque plus épaisse. D'autre part, elle peut être placée soit au dessous de l'élément photosensible, soit au dessus.

L'invention est applicable à la réalisation de détecteurs photosensibles linéaires ou matriciels, et aussi à la réalisation de détecteurs d'image radiologiques dans lesquels une couche scintillatrice convertit des rayons X incidents en rayons lumineux dans une gamme de longueurs d'ondes auxquelles le phototransistor NIPIN ou PINIP est sensible.

D'autres caractéristiques et avantages de l'invention apparaîtront à la lecture de la description détaillée qui suit et qui est faite en référence aux dessins annexés dans lesquels :

- La figure 1 représente symboliquement un point d'une matrice de points photosensibles, d'un type connu dans lequel une photodiode est placée en série avec une capacité entre une ligne et une colonne de la matrice;
- la figure 2 représente en vue de dessus la configuration géométrique de quelques points adjacents de la matrice;
- la figure 3 représente symboliquement un point d'une matrice photosensible selon l'invention;
- la figure 4 représente la structure générale du phototransistor utilisé dans la matrice selon l'invention;
- la figure 5 représente un mode de réalisation d'une matrice selon l'invention;
- la figure 6 représente un autre mode de réalisation;
- la figure 7 représente un troisième mode de réalisation.

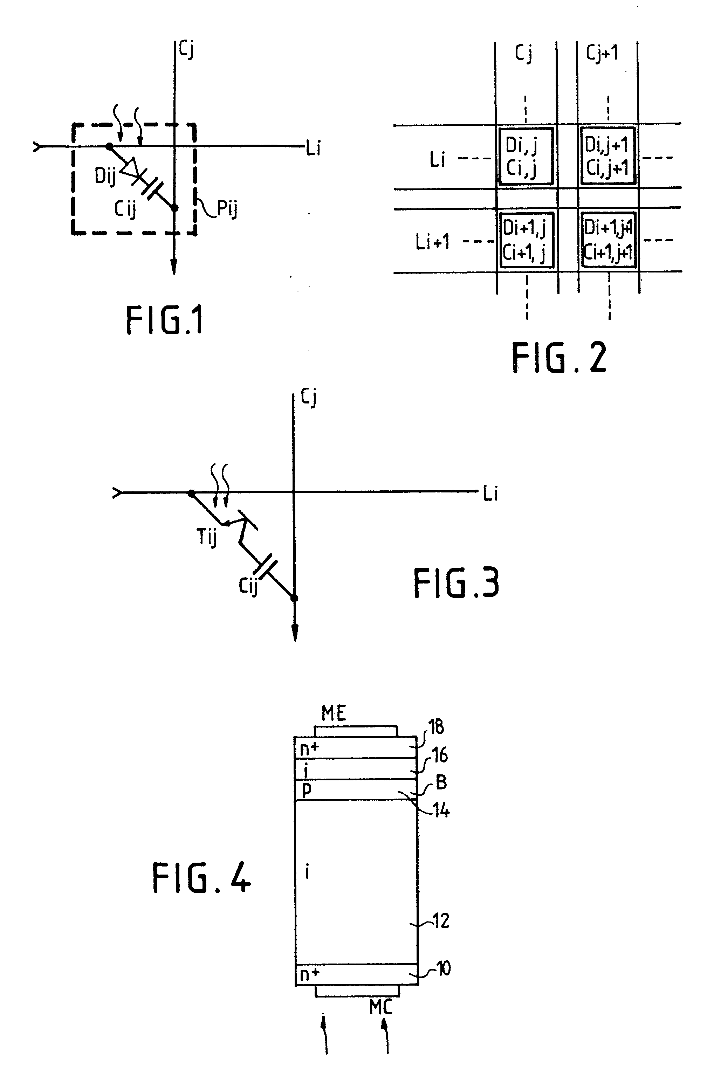

A la figure 1, on a représenté d'une manière symbolique un point d'une matrice de points photosensibles de la technique antérieure; cette matrice comporte un certain nombre de lignes et de colonnes et chaque point photosensible Pij est localisé au carrefour d'une ligne Li de rang i et d'une colonne Cj de rang j.

La ligne Li est matérialisée par un conducteur électrique orienté "horizontalement", et la colonne Cj est matérialisée par un conducteur Cj orienté "verticalement".

Le point photosensible comporte une photodiode Dij en série avec une capacité Cij; cet ensemble en série est connecté entre le conducteur de ligne Li et le conducteur de colonne Cj.

Lorsque la photodiode est illuminée, des charges électriques sont engendrées et stockées au point de jonction entre la diode et la capacité. On s'arrange pour que, pendant l'illumination, la diode soit polarisée en inverse aussi bien pour un faible éclairement que pour un fort éclairement (dans les limites de fonctionnement normal autorisées pour la matrice).

En dehors de la phase d'illumination, on lit les charges stockées en polarisant la diode en direct durant un bref instant; cette polarisation directe est faite en portant le conducteur de ligne à un potentiel approprié et elle permet de transférer les charges stockées vers la colonne Cj qui est reliée à un amplificateur de lecture.

La photodiode Dij est une diode PIN, qui présente de bonnes caractéristiques photoélectriques.

La figure 2 représente en vue de dessus la configuration géométrique de la matrice: cette configuration peut être très compacte car on réalise la photodiode (Dij) et la capacité (Cij) par simple empilement de couches semiconductrices (pour la diode) et isolantes (pour la capacité) entre les conducteurs de ligne et les conducteurs de colonne.

Pour plus de détails sur cette technique antérieure, on pourra se référer au brevet français 86 00716.

La figure 3 représente symboliquement un point photosensible d'une matrice selon l'invention.

La photodiode Dij est remplacée par un phototransistor Tij d'un type très particulier qui a l'avantage de posséder une sensibilité photoélectrique supérieure à celle d'une photodiode PIN (comme la plupart des phototransistors) mais qui, contrairement à ce qu'on pourrait attendre d'un phototransistor, peut être facilement rendu conducteur pour la lecture des charges stockées.

Le phototransistor utilisé de préférence selon l'invention est représenté à la figure 4; il comprend une superposition de cinq couches semiconductrices de types de conductivité différentes qui sont successivement:
- une couche collectrice 10 dopée d'un premier type de conductivité;
- une première couche intrinsèque 12;
- une couche de base 14 d'un deuxième type de conductivité opposé au premier;
- une deuxième couche intrinsèque 16;
- une couche émettrice 18 dopée du premier type de conductivité.

La couche émettrice et la couche collectrice peuvent être en contact avec une couche conductrice, respectivement ME et MC, mais ce n'est pas toujours indispensable; en particulier, du côté où le phototransistor est en série avec une capacité, la couche semiconductrice du premier type de conductivité peut constituer une électrode de la capacité sans qu'il soit nécessaire d'interposer une métallisation conductrice.

Dans les réalisations pratiques, notamment pour des matrices photosensibles de grandes dimensions, les couches semiconductrices seront en silicium amorphe.

De préférence, les couches du premier type de conductivité ont une épaisseur d'une centaine d'angströms ou plus; la couche de base du deuxième type a une épaisseur qui est de préférence d'une centaine d'angströms.

La première couche intrinsèque 12 est beaucoup plus épaisse que la deuxième; elle peut avoir une épaisseur de plusieurs milliers d'angströms alors que la deuxième aurait une épaisseur de 100 à 300 angströms. Plus la couche 16 est mince, plus il est facile de rendre conducteur le phototransistor en vue de la lecture des charges électriques engendrées par l'illumination et stockées par la capacité.

Les couches 14, 16, et 18 peuvent être dopées au carbone pour être plus transparentes au rayonnement lumineux incident, les charges électriques devant être engendrées principalement dans la première couche intrinsèque 12.

Toutes les couches de silicium amorphe doivent par ailleurs être dopées à l'hydrogène pour saturer les liaisons brisées du silicium et ainsi supprimer des défauts structurels des couches semiconductrices.

Le fonctionnement du point photosensible est le suivant : on travaille en trois phases qui sont une phase d'illumination, une phase de lecture et une phase de remise à niveau.

Pendant la phase d'illumination, la tension appliquée entre collecteur et émetteur du phototransistor est telle que la jonction collecteur-base est fortement polarisée en inverse, l'autre jonction base-émetteur étant légèrement polarisée en inverse. L'illumination engendre des porteurs dans la zone intrinsèque la plus épaisse ; ces porteurs s'accumulent sur la base et débloquent la jonction émetteur-base, ce qui provoque un courant de charges important (d'autant plus important que le gain du transistor est plus important), courant qui dirige des porteurs sur la capacité. Ces porteurs sont en nombre plus important que les porteurs initialement engendrés par l'illumination.

Dans la phase de lecture, en général dans l'obscurité, on applique une impulsion de tension sur le conducteur de ligne ou de colonne dans un sens qui polarise la jonction collecteur-base en direct, ce qui permet d'évacuer les charges stockées pendant l'intégration. Le courant d'évacuation est mesuré sur le conducteur de colonne. La tension de polarisation est faible et de l'ordre de celle qu'on utilise dans le cas des photodiodes.

Pendant la phase de remise à niveau, on restaure des potentiels initiaux qui doivent être toujours les mêmes au départ de l'illumination. Par exemple on éclaire le phototransistor avec un niveau d'éclairement important et on fait une lecture avec une impulsion plus faible que pendant la phase de lecture.

On va maintenant décrire des modes de réalisation pratique de l'invention.

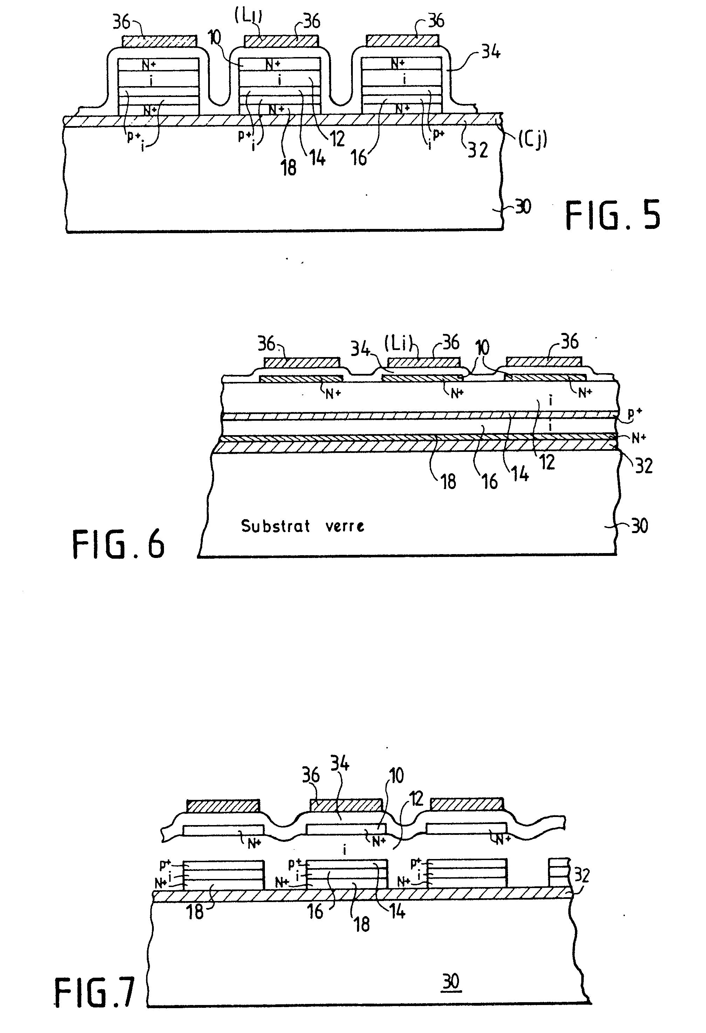

La figure 5 représente un premier mode de réalisation. Sur un substrat isolant 30, de préférence en verre transparent aux longueurs d'onde auxquelles sont sensibles les éléments photosensibles, on dépose un premier réseau de conducteurs parallèles 32 constituant par exemple les conducteurs de colonne Cj de la figure 3 (mais ce pourrait être aussi les conducteurs de ligne). Le matériau constituant ces conducteurs est de préférence un matériau transparent (oxyde d'indium-étain ITO), notamment dans le cas où on désire remettre à un niveau fixe le potentiel de la capacité Cij (figure 3) par un flash lumineux à l'arrière du substrat après chaque lecture.

Sur le substrat ainsi recouvert d'un réseau de conducteurs de lignes ou colonnes, on va déposer les couches semiconductrices servant à former les phototransistors et la couche isolante servant de diélectrique à la capacité, de manière à superposer, en chaque point de la matrice, un phototransistor et une capacité.

On peut soit former d'abord le phototransistor, soit former d'abord la capacité.

Dans le cas où on forme d'abord le phototransistor (figure 5), on dépose successivement sur le substrat des couches de silicium amorphe correspondant aux couches 10, 12, 14, 16, 18 décrites à propos de la figure 4. On peut les déposer dans cet ordre (couche collectrice au dessous et couche émettrice au dessus), ou dans l'ordre inverse (cas de la figure 5).

On grave ensuite cette superposition pour définir des îlots séparés correspondant chacun à un phototransistor qui sera localisé au dessus d'une portion de conducteur 32.

On dépose ensuite une couche isolante 34, par exemple en oxyde de silicium ou en nitrure de silicium, qui servira de diélectrique à la capacité. Cette couche recouvre les îlots et protège les jonctions sur les bords des îlots.

Enfin, on dépose une couche conductrice 36, transparente ou semi-transparente dans le cas où l'illumination se fait par le haut; par exemple, la couche 36 est en oxyde d'indium-étain; on la grave pour définir un réseau de conducteurs perpendiculaires aux conducteurs 32 et recouvrant les îlots correspondant aux phototransistors. Si les conducteurs 32 sont des conducteurs de ligne, alors les conducteurs de la couche 36 sont des conducteurs de colonne et réciproquement.

Le phototransistor est défini par la superposition des couches de silicium amorphe et la capacité qui lui est superposée est définie par la dernière couche (10) du premier type de conductivité, par la couche isolante 34 et par la couche conductrice 36.

Dans une variante de réalisation représentée à la figure 6, on considère qu'il n'est pas nécessaire d'isoler complètement les phototransistors les uns des autres par une gravure complète d'îlots de silicium amorphe séparés les uns des autres; on considère que certaines couches de silicium amorphe sont suffisamment résistives, du fait de leur faible dopage et/ou de leur faible épaisseur, pour que les fuites de courant entre îlots adjacents restent acceptables.

La réalisation de la figure 6 est analogue à celle de la figure 5, à l'exception du fait que l'opération de gravure des îlots de silicium amorphe après dépôt des cinq couches successives 18, 16, 14, 12, 10, consiste simplement à graver la dernière couche 10 du premier type de conductivité. Les couches intrinsèques 12 et 16 sont suffisamment résistives compte tenu de leur dopage quasiment nul; la couche de base 14 et la couche émettrice 18, si elle ne sont pas trop dopées, peuvent aussi être considérées comme suffisamment résistives du fait de leur faible épaisseur. Il faut s'assurer que l'application d'une impulsion de tension apte à rendre conducteurs les transistors connectés à une même ligne Li ne rend pas conducteurs les transistors des lignes voisines par l'intermédiaire de la couche N+ 18 non gravée.

D'autres variantes de réalisation, intermédiaires entre celle de la figure 5 (gravure totale des îlots) et celle de la figure 6 (gravure de la dernière couche du premier type de conductivité seulement) peuvent être prévues, ayant l'avantage par rapport à la figure 5 d'améliorer la planarisation de la surface de la structure après formation des îlots des silicium amorphe, ce qui facilite le dépôt et la gravure des conducteurs 36, mais ayant l'inconvénient de détériorer plus ou moins l'isolation entre points photosensibles de la matrice.

Par exemple, on peut prévoir un dépôt de la première couche du premier type de conductivité (couche 18 dans le cas de la figure 5), puis une gravure de cette couche selon des îlots séparés ou selon des bandes superposées aux bandes conductrices 32, puis un dépôt des couches suivantes 16, 14, 12, 10; on peut prévoir éventuellement une gravure de la couche 14 en îlots séparés avant le dépôt de la couche intrinsèque suivante 12.

Comme c'est la couche intrinsèque 12 du côté du collecteur qui est la plus épaisse et qui gêne donc le plus pour la planarisation, on peut prévoir une structure telle que celle de la figure 7, dans laquelle seule la couche 12 est déposée sans gravure; cette structure a l'avantage de minimiser le nombre d'étapes de gravure intermédiaires tout en évitant des fuites par les couches d'émetteur, de collecteur et de base qui sont les plus conductrices du fait de leur dopage, et tout en planarisant la structure d'une manière tout à fait favorable.

Le procédé de fabrication des phototransistors dans l'exemple de la figure 7 consiste à déposer d'abord les trois premières couches de silicium amorphe 18, 16, 14, puis à les graver en forme d'îlots, puis à déposer la couche intrinsèque épaisse 12 et la couche collectrice 10, et enfin à graver la couche collectrice 10 seulement en forme d'îlots.

Dans le cas où on préfère former la capacité en dessous et non au dessus du phototransistor (par exemple pour éviter une perte de rayonnement dans la couche diélectrique 34, on procède de la manière suivante: on dépose d'abord la couche conductrice 32 que l'on grave comme précédemment pour définir des bandes conductrices qui peuvent être des lignes ou des colonnes; puis on dépose la couche diélectrique 34, par exemple en oxyde ou nitrure de silicium; puis on forme le phototransistor par dépôt et gravure des couches successives de silicium amorphe (dans l'ordre de celles de la figure 5 ou dans l'ordre inverse), avec gravure complète des îlots de silicium amorphe ou avec gravure incomplète comme à la figure 6, avec gravures intermédiaires comme à la figure 7 ou sans gravure intermédiaire. Enfin, on dépose et on grave la couche conductrice 36 en bandes perpendiculaires aux bandes de la couche 32, ces bandes perpendiculaires recouvrant les phototransistors.

Lorsque le point photosensible comporte un phototransistor orienté comme à la figure 3, c'est-à-dire dans lequel la couche collectrice (celle qui est adjacente à la couche intrinsèque la plus épaisse) est située du côté des conducteurs de colonne tandis que la couche émettrice est située du côté des conducteurs de ligne, l'adressage d'un point photosensible (ou plus exactement d'une ligne de points) se fait par application d'une impulsion de tension suffisamment positive (pour un phototransistor NIPIN) sur le conducteur de ligne. Mais on peut envisager aussi que la couche collectrice soit située du côté des conducteurs de ligne.

On notera qu'il est préférable que l'éclairement se fasse du côté de la couche intrinsèque la plus épaisse; dans le cas où la matrice photosensible est associée à un scintillateur qui reçoit un rayonnement à une longueur d'onde à laquelle le phototransistor n'est pas sensible et qui le convertit en un rayonnemnt auquel il est sensible, le scintillateur peut être déposé au dessus de la structure finie, ou encore entre le substrat et le phototransistor; selon le cas, la couche intrinsèque la plus épaisse sera au dessus ou au dessous de la couche la moins épaisse.

L'invention est applicable notamment aux dispositifs de prise d'images radiologiques et tout particulièrement en vue de la prise d'images radiologiques de grandes dimensions pour des applications médicales, mais aussi plus généralement à toutes sortes de dispositifs de conversion d'images en signaux électriques.

**Revendications**

1. Réseau d'éléments photosensibles dans lequel chaque point du réseau comporte, entre un conducteur de ligne (Li) et un conducteur de colonne (Cj), une capacité (Cij) en série avec un élément photosensible, caractérisé en ce que l'élément photosensible est constitué par un phototransistor (Tij) susceptible d'être rendu conducteur aussi facilement qu'une photodiode même dans l'obscurité.

2. Réseau d'éléments photosensibles selon la revendication 1, caractérisé en ce que le phototransistor (Tij) est constitué par une superposition de couches semiconductrices (10, 12, 14, 16, 18) alternativement dopées de la manière suivante:
- dopage d'un premier type de conductivité;
- absence de dopage (semiconducteur intrinsèque ou quasi-intrinsèque);
- dopage du deuxième type de conductivité;
- absence de dopage (semiconducteur intrinsèque ou quasi-intrinsèque);
- dopage du premier type de conductivité.

3. Réseau d'éléments photosensibles selon la revendication 2, caractérisé en ce que la capacité comporte une couche diélectrique (34) en contact avec l'une des couches semiconductrices extrêmes (10 ou 18) de la superposition.

4. Réseau d'éléments photosensibles selon l'une des revendications 2 et 3, caractérisé en ce que l'une des couches semiconductrices non dopées (16) est beaucoup plus mince que l'autre (12).

5. Réseau d'éléments photosensibles selon la revendication 4, caractérisé en ce que la couche semiconductrice non dopée la moins épaisse (16) a une épaisseur de l'ordre d'une ou quelques centaines d'angströms.

6. Réseau d'éléments photosensibles selon l'une des revendications 4 et 5, caractérisé en ce que la couche semiconductrice non dopée la plus épaisse (12) a une épaisseur de l'ordre de plusieurs milliers d'angströms.

7. Réseau d'éléments photosensibles selon l'une des revendications 1 à 6, caractérisé en ce que le phototransistor est réalisé par un empilement de couches de silicium amorphe.

8. Réseau d'éléments photosensibles selon l'une des revendications 1 à 6, caractérisé en ce que le phototransistor est réalisé par un empilement de couches de silicium amorphe dans lequel certaines des couches seulement sont gravées pour définir des éléments photosensibles séparés les uns des autres, d'autres couches n'étant pas gravées, parmi lesquelles l'une au moins des couches semiconductrices non dopées.

FIG.1

FIG. 2

FIG.3

FIG. 4

FIG. 5

FIG. 6

Substrat verre

FIG.7

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | PATENT ABSTRACTS OF JAPAN, vol. 7, no. 255 (E-210)[1400], 12 novembre 1983, page 129 E 210; & JP-A-58 141 561 (HANDOUTAI ENERUGII KENKYUSHO K.K.) 22-08-1983 * Figures 1A,2-4 * | 1 | H 01 L 27/14 H 04 N 3/15 |
| A | IDEM. | 2,4,5,6,7,8 | |
| Y,D | EP-A-0 233 104 (THOMSON CSF) * Figures 1,5,6; colonne 7, ligne 40 - colonne 8, ligne 31 * | 1 | |
| A | | 3 | |
| A | EP-A-0 214 033 (THOMSON CSF) * Figure 2; colonne 3, ligne 43 - colonne 4, ligne 33 * | 1,2,7 | |
| A | US-A-4 633 287 (Y. SHUNPEI) * Figures 1-3; colonne 4, ligne 27 - colonne 6, ligne 30 * | 1,2,7 | DOMAINES TECHNIQUES RECHERCHES (Int. Cl.4) H 01 L H 04 N |

Le présent rapport a été établi pour toutes les revendications

| Lieu de la recherche | Date d'achèvement de la recherche | Examinateur |
|---|---|---|
| LA HAYE | 19-01-1989 | CARDON A. |